(19) **Europäisches Patentamt / European Patent Office / Office européen des brevets**

(11) **EP 3 842 862 B1**

(12) **EUROPEAN PATENT SPECIFICATION**

(45) Date of publication and mention of the grant of the patent:
**14.05.2025 Bulletin 2025/20**

(21) Application number: **19851799.7**

(22) Date of filing: **09.08.2019**

(51) International Patent Classification (IPC):
**G03F 7/00** *(2006.01)*     **G03F 7/033** *(2006.01)*
**G03F 7/027** *(2006.01)*     **G03F 7/032** *(2006.01)*
**G03F 7/20** *(2006.01)*     **G03F 7/037** *(2006.01)*

(52) Cooperative Patent Classification (CPC):
**G03F 7/027; G03F 7/032; G03F 7/033; G03F 7/037;**
G03F 7/202

(86) International application number:
**PCT/JP2019/031578**

(87) International publication number:
**WO 2020/039975 (27.02.2020 Gazette 2020/09)**

(54) **WATER-DEVELOPABLE FLEXO PRINTING PLATE ORIGINAL PLATE, FLEXO PRINTING PLATE, AND PHOTOSENSITIVE RESIN COMPOSITION**

WASSERENTWICKELBARE FLEXODRUCKPLATTENORIGINALPLATTE, FLEXODRUCKPLATTE UND LICHTEMPFINDLICHE HARZZUSAMMENSETZUNG

PLAQUE ORIGINALE DE PLAQUE D'IMPRESSION FLEXOGRAPHIQUE DÉVELOPPABLE À L'EAU, PLAQUE D'IMPRESSION FLEXOGRAPHIQUE ET COMPOSITION DE RÉSINE PHOTOSENSIBLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.08.2018 JP 2018156569**

(43) Date of publication of application:
**30.06.2021 Bulletin 2021/26**

(73) Proprietor: **FUJIFILM Corporation Tokyo 106-8620 (JP)**

(72) Inventors:
• **SATO Hiroshi**
  **Haibara-gun, Shizuoka 421-0396 (JP)**
• **FUJIMAKI Kazuhiro**
  **Haibara-gun, Shizuoka 421-0396 (JP)**

(74) Representative: **Hoffmann Eitle Patent- und Rechtsanwälte PartmbB Arabellastraße 30 81925 München (DE)**

(56) References cited:
**JP-A- 2002 196 479     JP-A- H05 112 655
JP-A- H05 204 139     JP-A- H05 501 457
US-A1- 2002 051 928**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND OF THE INVENTION**

1. Field of the Invention

The present invention relates to a water-developable flexographic printing plate precursor, a flexographic printing plate, and a photosensitive resin composition.

2. Description of the Related Art

In recent years, various industries have started to reduce the use of organic solvents from the viewpoint of improving the working environment and preserving the global environment, and in a plate making step of a photosensitive flexographic printing plate used for printing, the use of an aqueous developable photosensitive resin plate is increasing.

For example, JP-A-2010-256860 discloses a "photosensitive resin composition for a flexographic printing plate, including at least (A) a hydrophobic polymer obtained from a water-dispersed latex, (B) a hydrophilic polymer, (C) an ethylenic double bond unsaturated compound, and (D) a photopolymerization initiator, in which the hydrophobic polymer obtained from the water-dispersed latex of the component (A) consists of three kinds of polybutadiene, acrylonitrile-butadiene copolymer, and methyl methacrylate-based copolymer" ([claim 1]), and a photosensitive resin precursor for flexographic printing in which a photosensitive resin layer obtained by using this photosensitive resin composition for a flexographic printing plate and a support are laminated ([claim 5]).

In addition, JP-A-2017-076059 discloses a "photosensitive resin composition for flexographic printing, including at least (A) a hydrophilic copolymer, (B) an elastomer, (C) a polymerizable unsaturated monomer, (D) a plasticizer including a polymer which includes repeating units derived from a conjugated diene compound and has a carboxyl group in at least one repeating unit, and (E) a photopolymerization starting material" ([claim 1]), and a flexographic printing plate precursor formed of this photosensitive resin composition for flexographic printing ([claim 8]).

JP-A-1993-112655 describes different resins (1)-(3), i.e. (1) a resin having self-dispersing ability and self-crosslinking ability and a glass transition temperature (Tg) of $\leq 0°C$, (2) a hydrophobic resin having self-crosslinking ability and a Tg of $\leq 0°C$, (3) a resin having a Tg of $\geq 20°C$ higher than the Tg of the resin (1), or a monofunctional monomer which gives such a resin when mixed alone, or a mixture of both.

JP-A-1993-204139 discloses a photosensitive composition for a water-developable flexographic printing material, which composition contains (a) 10-99 pbw of resin particles having an average particle size of 0.01-5 $\mu$m and a core/shell structure in which at least the shell has a three-dimensional crosslinking structure, (b) 1-90 pbw of compound having photoreactive groups, and (c) 0.01-10 pbw of photopolymerization initiator, each based on the total of (a), (b) and (c) taken as 100 pbw..

JP-A-1993-501457 relates to a method comprising the steps of (a) mixing at least one binder selected from a reactive or non-reactive binder and at least one photoinitiator in the form of a dispersion and, if said binder is non-reactive, adding at least one reactive component which can react with the photoinitiator to form a substantially homogeneous dispersion; (b) condensing the product of process (a) to form a condensate and a liquid; and (c) forming a substantially homogeneous dispersion by a specified method for preparing a photosensitive composition having a low thermal history.

**SUMMARY OF THE INVENTION**

The present inventors have conducted an investigation on the water-developable flexographic printing plate precursor disclosed in JP-A-2010-256860 and JP-A-2017-076059, and thus have found that image reproducibility (hereinafter, abbreviated as "water developability") using an aqueous developer is good. However, it has been clarified that, after using this aqueous developer for one or more times of development, in a case of reusing this aqueous developer as a developer, at the time of washing (rinsing) the developer remaining on the printing plate with water, a dispersion in the developer may adhere to the printing plate to cause contamination on a printed matter, or in a case of discarding this aqueous developer as a used developer, at the time of diluting the used developer with water in a drainage system, the dispersion in the developer may aggregate to cause clogging a drainage pipe.

Therefore, an object of the present invention is to provide a water-developable flexographic printing plate precursor, a flexographic printing plate, and a photosensitive resin composition, which can maintain good water developability and can suppress adhesion and aggregation of dispersion in the developer in a case of repeated use and disposal of the aqueous developer.

As a result of intensive investigations to achieve the above-described objects, the present inventors have found that, by using a photosensitive layer or a photosensitive resin composition containing water-dispersible particles which have a core containing a polymer and having a glass transition temperature of $\leq 0°C$ and have a shell containing a polymer and having a glass transition temperature of ≥ 10°C, it is possible to maintain good water developability and suppress adhesion and aggregation of dispersion in the developer in a case of repeated use and disposal of the aqueous developer, and thus have completed the present invention.

That is, the present invention provides a printing plate precursor, which is a water-developable flexographic printing plate precursor comprising a photosensitive layer containing water-dispersible particles which have

- a core containing a polymer and having a glass transition temperature (Tg) of ≤ 0°C and
- a shell containing a polymer and having a Tg of ≥ 10°C,

the Tg being measured by DSC in accordance with JIS K 7121 (1987) by the method defined in the description, wherein the polymer contained in the shell contains 2-12 mass% of a constitutional unit derived from a monomer containing an acid group which is at least one acid group selected from a carboxy group, a sulfo group, a phosphoric acid group, and salts thereof and a constitutional unit derived from at least one monomer selected from acrylic and methacrylic acid esters having an alicyclic C≥6-hydrocarbon group, acrylamides, methacrylamides, acrylonitrile and methacrylonitrile.

Also, the present invention provides a photosensitive resin composition comprising a hydrophobic polymer; a photopolymerizable monomer; a photopolymerization initiator; and water-dispersible particles as defined above.

Preferred embodiments of the invention are as defined in the appended dependent claims and/or in the following detailed description.

According to the present invention, it is possible to provide a water-developable flexographic printing plate precursor, a flexographic printing plate, and a photosensitive resin composition, which can maintain good water developability and can suppress adhesion and aggregation of dispersion in the developer in a case of repeated use and disposal of the aqueous developer.

## DESCRIPTION OF THE PREFERRED EMBODIMENTS

Hereinafter, the present invention will be described in detail.

In this specification, the numerical range expressed by using "to" means a range including the numerical values before and after "to" as the lower limit value and the upper limit value.

In addition, in this specification, for each component, one kind of substance corresponding to each component may be used alone, or two or more kinds thereof may be used in combination. Here, in a case where two or more kinds of substances are used in combination for each component, the content of the component indicates the total content of the substances used in combination, unless otherwise specified.

In addition, in this specification, "(meth)acrylate" represents a notation of "acrylate" or "methacrylate", "(meth) acryl" represents a notation of "acryl" or "methacryl", and "(meth)acryloyl" represents a notation of "acryloyl" or "methacryloyl".

[Water-developable flexographic printing plate precursor]

A water-developable flexographic printing plate precursor according to an embodiment of the present invention (hereinafter, also abbreviated as "the present printing plate precursor") is a water-developable flexographic printing plate precursor including a photosensitive layer which contains water-dispersible particles.

In addition, the water-dispersible particles are core-shell particles which have a core containing a polymer and having a glass transition temperature of ≤ 0°C and have a shell containing a polymer and having a glass transition temperature of ≥ 10°C.

As described above, in the present invention, by using a photosensitive layer containing water-dispersible particles which have a core containing a polymer and having a glass transition temperature of ≤ 0°C and have a shell containing a polymer and having a glass transition temperature of ≥ 10°C, it is possible to maintain good water developability and suppress adhesion and aggregation of dispersion in the developer in a case of repeated use and disposal of the aqueous developer.

Although the details thereof are not clear, the present inventors have assumed as follows.

First, the aqueous developer is usually used repeatedly for two or more times of development, but for example, in the developer used for the second development, a plate material removed from the flexographic printing plate precursor by the first development, that is, a plate material in an unexposed area (uncured area) is present as a dispersion.

Then, as shown in the comparative example described later, in a case of containing water-dispersible particles which have a core containing a polymer and having a glass transition temperature of ≤ 0°C and have a shell containing a polymer and having a glass transition temperature of lower than 10°C, it can be seen that water developability is inferior and it is not possible to suppress the adhesion and aggregation of the dispersion in the developer.

Therefore, in the present invention, since the water-dispersible particles which have a core containing a polymer and having a glass transition temperature of ≤ 0°C and have a shell containing a polymer and having a glass transition temperature of ≥ 10°C are also included in the dispersion present in the developer, it is considered that it is possible to alleviate the external force (for example, dilution, and stirring) on the dispersion and suppress the deformation and aggregation of the dispersion.

Hereinafter, the photosensitive layer of the present printing plate precursor will be described in detail.

[Photosensitive layer]

As described above, the photosensitive layer of the present printing plate precursor contains water-dispersible particles which have a core containing a polymer and having a glass transition temperature of ≤ 0°C and have a shell containing a polymer and having a glass transition temperature (Tg) of ≥ 10°C.

Here, the glass transition temperature is measured by using a differential scanning calorimeter [manufactured by Seiko Instruments Inc., product name: "DSC-6200"] in accordance with JIS K 7121 (1987) (measuring method of transition temperature of plastic).

Specifically, 3 mg of a powder sample obtained by recovering the material included in the core or shell is heated (heating rate: 10 °C/min) under a nitrogen atmosphere (gas flow rate: 80 ml/min) and measured twice, and the second data is adopted.

In a case where it is difficult to separate the material included in the core from the material included in the shell, the glass transition temperatures of the core and the shell can be specified by measuring glass transition temperature according to the above-described method using 3 mg of a powder sample obtained by recovering the water-dispersible particles, drying an aqueous dispersion liquid including the water-dispersible particles at a temperature intermediate between two observed glass transition temperatures, and checking whether the particles are fused to form a continuous film or the particles are not fused to form a continuous film (but are to be powdered). For example, in a case where the glass transition temperatures are observed at -20°C and 50°C, after drying the aqueous dispersion liquid including water-dispersible particles at 20°C, in a case of a continuous film, it can be determined that -20°C is the glass transition temperature of the shell and 50°C is the glass transition temperature of the core, and in a case of powder, it can be determined that the glass transition temperature of the shell is 50°C and the glass transition temperature of the core is -20°C.

<Water-dispersible particles>

As described above, the water-dispersible particles contained in the photosensitive layer are core-shell particles which have a core containing a polymer and having a glass transition temperature of 0°C ≤ and have a shell containing a polymer and having a glass transition temperature of ≥ 10°C.

Here, the shell is not limited to covering the entire surface of the core, but may cover at least a part of the surface of the core or cover at least a part of a surface of an interlayer covering the surface of the core.

In the present invention, the content of the water-dispersible particles is preferably 10-70 mass%, more preferably 20-60 mass%, and still more preferably 30-50 mass% with respect to the total solid content mass of the photosensitive layer.

In addition, in the present invention, from the reason that it is easy to synthesize particles of homogeneous size, the average particle size of the water-dispersible particles is preferably 5-500 nm and more preferably 30-300 nm.

Here, the average particle size refers to a value measured by a dynamic light scattering method using an aqueous dispersion liquid including water-dispersible particles.

(Core)

In the present invention, from the viewpoint of modulus of film elasticity of the obtained photosensitive layer, the glass transition temperature of the core in the water-dispersible particles is preferably -20°C or lower and more preferably -40°C or lower.

In addition, in the present invention, from the reason that aqueous ink resistance of the obtained photosensitive layer is improved and the modulus of film elasticity is also improved, it is preferable that the polymer contained in the core is a hydrophobic polymer.

Here, regarding the hydrophobicity of the polymer, from the viewpoint of the aqueous ink resistance of the obtained photosensitive layer, the Hansen solubility parameter (hereinafter, simply abbreviated as an "HSP value") is preferably 8-12, more preferably 8.5-11, and still more preferably 8.5-10.5.

In addition, the details of the HSP value is described in Hansen, Charles (2007)., Hansen Solubility Parameters: A user's handbook, Second Edition., Boca Raton, Fla: CRC Press., ISBN 9780849372483.

In addition, the HSP value is calculated by inputting structural formula of the compound into the following software, and more specifically, the HSP value is a value corresponding to δtotal. As the software, Hansen Solubility Parameters in Practice (HSPiP), ver. 4.1.07 is used.

Suitable examples of the polymer contained in the core include a polymer having a constitutional unit derived from at least one monomer selected from a $C_{2-12}$-acrylic acid ester, a $C_{6-14}$-methacrylic acid ester, and a conjugated diene-based hydrocarbon.

Specific examples of the $C_{2-12}$-acrylic acid ester include ethyl acrylate, n-propyl acrylate, isopropyl acrylate, n-butyl acrylate, t-butyl acrylate, 2-ethylhexyl acrylate, and dodecyl acrylate.

Specific examples of the $C_{6-14}$-methacrylic acid ester include 2-ethylhexyl methacrylate, isobornyl methacrylate, and dodecyl methacrylate.

Specific examples of the conjugated diene-based hydrocarbon include 1,3-butadiene, isoprene, and chloroprene.

In addition to the above-described monomers, as a monomer copolymerized with the above-described monomers, for example, styrene, α-methylstyrene, o-methylstyrene, m-methylstyrene, p-methylstyrene, acrylonitrile, methacrylonitrile, vinyl chloride, vinylidene chloride, acrylamide, metacrylamide, vinyl methacrylamide acetate, an acrylic acid ester other than the above-described $C_{2-12}$-acrylic acid ester, and a methacrylic acid ester other than the above-described $C_{6-14}$-methacrylic acid ester can be used.

(Shell)

In the present invention, from the reason that it is possible to further suppress adhesion and aggregation of dispersion in the developer in a case of repeated use and disposal of the aqueous developer, the glass transition temperature of the shell in the water-dispersible particles is preferably ≥ 40°C and more preferably ≥ 60°C.

In addition, in the present invention, from the reason that water developability of the obtained photosensitive layer is improved, the polymer contained in the shell is a polymer containing 2-12 mass% of a constitutional unit derived from a monomer containing an acid group.

From the reason that the water developability is improved and it is possible to further suppress adhesion and aggregation of dispersion in the developer in a case of repeated use and disposal of the aqueous developer, the acid group is at least one group selected from a carboxylic acid group (carboxy group), sulfonic acid (sulfo group), and a phosphoric acid group. Among these, a carboxy group or a sulfo group is preferable.

In addition, the acid group may be in a form of a salt, and specific examples of the salt include salts of alkali metal such as sodium, potassium, and lithium, and salts of alkaline earth metal such as calcium and magnesium.

Specific examples of the acid group-containing monomer include acrylic acid, methacrylic acid, itaconic acid, crotonic acid, isocrotonic acid, maleic acid, and sodium styrene sulfonate.

From the reason that aqueous ink resistance of the obtained photosensitive layer is good and the water developability is also improved, the polymer contains 2-12 mass% of the constitutional unit derived from the acid group-containing monomer, preferably 4-11 mass% thereof, and more preferably 5-10 mass%.

In the present invention, the polymer contained in the shell is preferably a polymer having a constitutional unit derived from a compound which has a radically polymerizable ethylenically unsaturated bond.

Examples of the compound which has a radically polymerizable ethylenically unsaturated bond include, in addition to the above-described acid group-containing monomer, nitrogen-containing radically polymerizable compounds such as an N-vinyl compound, acrylamide, and methacrylamide; unsaturated carboxylic acid esters such as acrylic acid ester, methacrylic acid ester, itaconic acid ester, crotonic acid ester, isocrotonic acid ester, and maleic acid ester, and salts thereof; anhydrides having an ethylenically unsaturated group; acrylonitrile; styrene; and macromonomers such as an unsaturated polyester, an unsaturated polyether, an unsaturated polyamide, and an unsaturated polyurethane.

In the present invention, from the reason that it is possible to further suppress adhesion and aggregation of dispersion in the developer in a case of repeated use and disposal of the aqueous developer, the polymer contained in the shell is a polymer having a constitutional unit derived from at least one monomer selected from acrylic and methacrylic acid esters having an alicyclic $C_{\geq 6}$-hydrocarbon group, acrylamides, methacrylamides, acrylonitrile, and methacrylonitrile.

Here, specific examples of the alicyclic $C_{\geq 6}$-hydrocarbon group include cyclohexyl, 2-decahydronaphthyl, adamantyl, 1-methyladamantyl, 2-methyladamantyl, 2-ethyladamantyl, a 2-norbornyl, 5,6-dimethyl-norbornyl, 3-methyl-2-norbornyl, isobornyl, dicyclopentanyl, and dicyclopentenyl.

Specific examples of the (meth)acrylic acid ester having an alicyclic $C_{\geq 6}$-hydrocarbon group include cyclohexyl (meth)acrylate, isobornyl (meth)acrylate, dicyclopentanyl (meth)acrylate, and 2-methyl-2-adamantyl (meth)acrylate.

Specific examples of the (meth)acrylamides include acrylamide, methacrylamide, N-butylacrylamide, N,N-dimethylacrylamide, N,N-diisopropylacrylamide, N,N-dibutylacrylamide, morpholylacrylamide, piperidyl acrylamide, and N-tert-butylmethacrylamide.

In the present invention, from the viewpoint of resistance to solvent ink, the shell in the water-dispersible particles may be crosslinked. Therefore, the polymer contained in the shell may contain an ethylenically unsaturated group at the terminal of the molecule or the side chain in the molecule, so as to be able to react with a photopolymerizable monomer or a crosslinking agent or so as to be able to react between the polymers.

In the present invention, from the reason that aqueous ink resistance of the obtained photosensitive layer is good and the modulus of film elasticity is also improved, the ratio (core/shell) of the mass of the core to the mass of the shell is preferably $\geq 1$, more preferably $\geq 1.4$, and still more preferably $\geq 2.0$.

The flexographic printing plate precursor according to the embodiment of the present invention may be a so-called analog type printing plate precursor in which a negative film (film on which an image is already formed) is closely attached to the photosensitive layer at the time of use, or may be a laser ablation mask (LAM) type printing plate precursor, in which an infrared ablation layer is closely attached to the photosensitive layer in advance, the LAM type being included in a so-called computer to plate (CTP) type.

The analog type printing plate precursor is a printing plate precursor in which e.g. a substrate, or an adhesive layer composed of an adhesive which adheres the substrate and a photosensitive layer, a photosensitive layer composed of the present photosensitive resin composition described later, an anti-adhesion layer to prevent the surface of the photosensitive layer from adhering, and a protective film preventing scratches on the photosensitive resin composition before use are laminated in this order.

Specific examples of the substrate include plastic films such as a polyethylene terephthalate (PET) film or plastic sheets; metal sheets such as stainless and aluminum; and rubber sheets such as butadiene rubber.

In the analog type printing plate precursor, the protect film is peeled off at the time of use, and the negative film on which an image is formed in advance is closely attached to the exposed anti-adhesion layer.

The analog type printing plate precursor can be manufactured by, for example, applying an adhesive in advance to one surface of the substrate and applying an anti-adhesion agent in advance to one surface of the protective film, interposing the present photosensitive resin composition described later between the substrate to which the adhesive is applied in advance and the protective film to which the anti-adhesion agent is applied in advance, and pressing the printing plate precursor such that the thickness of the photosensitive resin composition is a predetermined thickness.

The LAM type printing plate precursor is different from the analog type printing plate precursor in that the LAM type printing plate precursor has an infrared ablation layer between the photosensitive layer and the protective film, and other configurations are the same as the analog type printing plate precursor. That is, the adhesive layer, the photosensitive layer, the infrared ablation layer, and the protective film are laminated on the substrate in this order. In the LAM type printing plate precursor, the protective film is peeled off at the time of use to expose the infrared ablation layer.

The infrared ablation layer is a layer capable of removing a portion irradiated by an infrared laser, and the infrared ablation layer itself is a layer which also has a function of blocking the transmission of ultraviolet rays at a practical level. By forming an image on the infrared ablation layer, the infrared ablation layer can serve as a negative film or a positive film.

The infrared ablation layer is mainly composed of e.g. a binder such as resin and rubber, an infrared absorbing substance, an ultraviolet absorbing substance, and plasticizer. The infrared ablation layer can be manufactured by, for example, dissolving the above-described materials in a solvent, applying the solution to a base material, and drying the solution to remove the solvent.

The LAM type printing plate precursor can be manufactured by, for example, applying an adhesive in advance to one surface of the substrate and coating one surface of the protective film with an infrared ablation layer in advance, interposing the present photosensitive resin composition between the substrate to which the adhesive is applied in advance and the protective film which is coated with the infrared ablation layer in advance, and pressing the printing plate precursor such that the thickness of the photosensitive resin composition is a predetermined thickness.

In any of the printing plate precursors, the thickness of the photosensitive layer is preferably 0.01-10 mm. In a case where the thickness of the photosensitive layer is $\geq 0.01$ mm, a sufficient relief depth can be secured. On the other hand, in a case where the thickness of the photosensitive layer is $\leq 10$ mm, the weight of the printing plate precursor can be suppressed, and the printing plate precursor can be practically used as a printing plate.

[Flexographic printing plate]

A flexographic printing plate in the present invention is a flexographic printing plate including an image area and a non-image area.

In addition, the image area included in the flexographic printing plate is an image area obtained by imagewise exposing the photosensitive layer of the present printing plate precursor, and developing the exposed photosensitive layer.

In order to form a relief image on the photosensitive layer of the printing plate precursor, first, ultraviolet irradiation is performed on the substrate side of the printing plate precursor (back exposure).

In a case of using the analog type printing plate precursor, the protect film is peeled off, and the negative film on which an image is formed in advance is closely attached to the exposed anti-adhesion layer. On the other hand, in a case of using the LAM type printing plate precursor, the protective film is peeled off, and a desired image is formed by, for example, irradiating the exposed infrared ablation layer with an infrared laser.

Next, the photosensitive layer is cured by irradiating ultraviolet rays from above the negative film or the infrared ablation layer (main exposure). The ultraviolet rays can be usually irradiated from e.g. a high-pressure mercury lamp, an ultrahigh-pressure mercury lamp, a metal halide lamp, a xenon lamp, a carbon arc lamp, and a chemical lamp, which can perform irradiation with light having a wavelength of 300-400 nm. An irradiated portion of the photosensitive layer is cured by irradiation with ultraviolet rays. The photosensitive layer covered with the negative film or the infrared ablation layer has a cured portion irradiated with ultraviolet rays and an uncured portion not irradiated with ultraviolet rays.

Next, the relief image is formed by removing the uncured portion of the photosensitive layer in the developer. As the developer, an aqueous developer is used. The aqueous developer is composed of water to which e.g. a surfactant, or pH adjuster is added as necessary. The uncured portion of the photosensitive layer can be removed by, for example, washing out the uncured portion using a spray type developing device or a brush type washing machine.

Next, the printing plate material is taken out from the developer and dried. Next, the entire dried printing plate material is irradiated with ultraviolet rays as necessary (post exposure). As a result, a flexographic printing plate is obtained.

[Photosensitive resin composition]

The present photosensitive resin composition is a resin composition containing water-dispersible particles (A), a hydrophobic polymer (B), a photopolymerizable monomer (C), and a photopolymerization initiator (D).

In addition, in the present photosensitive resin composition, the water-dispersible particles (A) are water-dispersible particles which have a core containing a polymer and having a glass transition temperature of $\leq 0°C$ and have a shell containing a polymer and having a glass transition temperature of $\geq 10°C$.

Hereinafter, the water-dispersible particles (A), the hydrophobic polymer (B), the photopolymerizable monomer (C), the photopolymerization initiator (D), and optional components contained in the present photosensitive resin composition will be described in detail.

[Water-dispersible particles (A)]

The water-dispersible particles (A) contained in the present photosensitive resin composition are water-dispersible particles which have a core containing a polymer and having a glass transition temperature of $\leq 0°C$ and have a shell containing a polymer and having a glass transition temperature of $\geq 10°C$, and are the same as those described in connection with the present printing plate precursor above.

In addition, the water-dispersible particles (A) may be contained in an aqueous dispersion liquid, and the content (concentration of solid contents) of the water-dispersible particles (A) in this case is preferably 5-50 mass%, more preferably 10-40 mass%, and still more preferably 15-30 mass%.

[Hydrophobic polymer (B)]

The hydrophobic polymer (B) contained in the present photosensitive resin composition is not particularly limited, and for example, a thermoplastic polymer can be used.

The thermoplastic polymer is not particularly limited as long as thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer.

Among these, from the reason that an elastic and flexible film can be easily formed, rubbers or a thermoplastic elastomer is preferable.

Specific examples of the rubbers include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer, and chlorinated polyethylene. These may be used alone or in combination of two or more. Among these rubber materials, from the reason that the water developability is improved, or from the viewpoint of drying properties and image reproducibility, at least one rubber selected from butadiene rubber (BR) and nitrile rubber (NBR) is preferable.

Examples of the thermoplastic elastomer include a polybutadiene-based thermoplastic elastomer, a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that the water developability is improved, or from the viewpoint of drying properties and image reproducibility, SBS or SIS is particularly preferable.

In addition, regarding the hydrophobicity of the hydrophobic polymer (B), the HSP value is preferably 8-12, more preferably 8.5-11, and still more preferably 8.5-10.5.

The content of the hydrophobic polymer (B) is preferably 5-60 mass% and still more preferably 10-40 mass% with respect to the total mass the solid content of the photosensitive resin composition.

[Photopolymerizable monomer (C)]

The photopolymerizable monomer (C) contained in the present photosensitive resin composition is not particularly limited, and photopolymerizable monomers used in known flexographic printing plates in the related art can be used.

Examples of the photopolymerizable monomer (C) include ethylenically unsaturated compounds.

The ethylenically unsaturated compound may be a monofunctional ethylenically unsaturated compound or a polyfunctional ethylenically unsaturated compound, but is preferably a polyfunctional ethylenically unsaturated compound.

Suitable examples of the polyfunctional ethylenically unsaturated compound include a compound having 2-20 terminal ethylenically unsaturated groups, and specific examples thereof include alkanediol (meth)acrylate compounds such as 1,3-butanediol dimethacrylate, 1,4-butanediol diacrylate, 1,4-butanediol dimethacrylate, 1,6-hexanediol diacrylate, 1,6-hexanediol dimethacrylate, 1,9-nonanediol diacrylate, 1,9-nonanediol dimethacrylate, 1,12-dodecanediol diacrylate, and 1,12-dodecanediol dimethacrylate;

glycol di(meth)acrylate compounds such as ethyleneglycol di(meth)acrylate, diethyleneglycol di(meth)acrylate, triethyleneglycol di(meth)acrylate, tetraethyleneglycol di(meth)acrylate, polyethyleneglycol di(meth)acrylate, propyleneglycol di(meth)acrylate, dipropyleneglycol di(meth)acrylate, tripropyleneglycol di(meth)acrylate, tetrapropyleneglycol di(meth)acrylate, polypropyleneglycol di(meth)acrylate, ethoxylated neopentylglycol di(meth)acrylate, and propoxylated neopentylglycol di(meth)acrylate;

di or trivinyl ether compounds such as ethyleneglycol divinyl ether, diethyleneglycol divinyl ether, triethyleneglycol divinyl ether, propyleneglycol divinyl ether, dipropyleneglycol divinyl ether, butanediol divinyl ether, hexanediol divinyl ether, cyclohexanedimethanol divinyl ether, and trimethylolpropane trivinyl ether;

di(meth)acrylate compounds of bisphenol A such as bisphenol A diglycidyl ether (meth)acrylic acid adduct, modified bisphenol A di(meth)acrylate, bisphenol A PO-adducted di(meth)acrylate, and bisphenol A EO-adducted di(meth)acrylate;

tri or more valent ester compounds of alcohol such as pentaerythritol tri(meth)acrylate, pentaerythritol tetra(meth)acrylate, dipentaerythritol tetra(meth)acrylate, trimethylolethane tri(meth)acrylate, trimethylolpropane tri(meth)acrylate, and tetramethylolmethane tetra(meth)acrylate; allyl compounds such as diallyl phthalate and triallyl trimeritate; and

bis(4-(meth)acryloxipolyethoxyphenyl) propane.

PO represents propylene oxide and EO represents ethylene oxide.

The content of the photopolymerizable monomer (C) is preferably 0.1-30 mass% and still more preferably 1-20 mass% with respect to the total mass the solid content of the photosensitive resin composition.

[Photopolymerization initiator (D)]

The photopolymerization initiator (D) contained in the present photosensitive resin composition is not particularly limited as long as the photopolymerization of the above-described photopolymerizable monomer is initiated, and examples thereof include photopolymerization initiators such as alkylphenones, acetophenones, benzoin ethers, benzophenones, thioxanthones, anthraquinones, benzyls, and biacetyls.

Specific examples thereof include benzyl dimethyl ketal, 2-hydroxy-2-methyl-1-phenyl-propane-1-one, methyl-o-benzoylbenzoate, and 1-hydroxycyclohexyl phenyl ketone.

From the viewpoint of e.g. sensitivity, the content of the photopolymerization initiator (D) is preferably 0.3-15 mass% and still more preferably 0.5-10 mass% with respect to the total mass the solid content of the photosensitive resin composition.

[Plasticizer (E)]

From the viewpoint of imparting flexibility to the photosensitive resin composition, it is preferable that the present photosensitive resin composition contains a plasticizer (E).

Examples of the plasticizer (E) include liquid rubber, oil, polyester, and phosphoric acid-based compounds.

Specific examples of the liquid rubber include liquid polybutadiene, liquid polyisoprene, and compounds in which these compounds are modified with maleic acid or an epoxy group.
Specific examples of the oil include paraffin, naphthene, and aroma.
Specific examples of the polyester include adipic acid-based polyester.
Specific examples of the phosphoric acid-based compound include phosphoric acid ester.
In the present invention, from the viewpoint of flexibility, in a case where a plasticizer (E) is contained, the content of the plasticizer (E) is preferably 0.1-40 mass% and still more preferably 5-30 mass% with respect to the total mass the solid content of the photosensitive resin composition.

[Surfactant (F)]

From the viewpoint of further improving water developability, it is preferable that the present photosensitive resin composition contains a surfactant (F).
Examples of the surfactant include a cationic surfactant, an anionic surfactant, and a nonionic surfactant. Among these, an anionic surfactant is preferable.
Specific examples of the anionic surfactant include

aliphatic carboxylates such as sodium laurate, and sodium oleate;
higher alcohol sulfate ester salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkyl allyl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate monoester, and sodium polyoxyethylene lauryl ether phosphate diester.

These may be used alone or in combination of two or more.

Among these, from the reason that water developability of the photosensitive resin composition is further improved, sulfonic acid-based surfactants such as alkyl sulfonate and alkyl allyl sulfonate are preferable.

In the present invention, from the viewpoint of developability and drying properties after development, in a case where a surfactant (F) is contained, the content of the surfactant (F) is preferably 0.1-20 mass% and still more preferably 1-10 mass% with respect to the total mass the solid content of the photosensitive resin composition.

[Polymerization inhibitor]

From the viewpoint of improving heat stability during kneading and improving storage stability, a thermal polymerization inhibitor (stabilizer) can be added to the present resin composition.
Examples of the thermal polymerization inhibitor include phenols, hydroquinones, and catechols.
The content of the thermal polymerization inhibitor in the photosensitive resin composition is generally in a range of 0.001-5 mass%.

[Other additives]

To the extent that the effects of the present invention are not impaired, other additives such as an ultraviolet absorber, a dye, a pigment, an antifoaming agent, and a fragrance can be appropriately added to the present resin composition for the purpose of improving various properties.

Examples

Hereinafter, the present invention will be described in more detail with reference to examples.

[Synthesis Example 1]

193.8 g of distilled water and 3 g of a 30% aqueous solution of sodium dodecylbenzenesulfonate were charged into a flask, and the solution was heated to 80°C under nitrogen gas.

Next, 12.5% of a mixture of 109.4 g of 2-ethylhexyl acrylate, 1.12 g of allyl methacrylate, and 1.12 g of 1,4-butanediol diacrylate was added thereto at one time.

Next, 1.5 ml of a 7% aqueous solution of sodium phosphate and 1.5 ml of a 5% aqueous solution of ammonium persulfate were added thereto. The rest of the monomer mixture was added thereto over 90 minutes while keeping the temperature at 83-88°C.

Next, after addition, the reaction mixture was heated at 80-85°C for another 2 hours, and then filtered to obtain a core emulsion including a core having a particle size of 90 nm.

Next, 200 g of the obtained core emulsion and 0.048 g of potassium persulfate were added to a flask. 130.3 g of distilled water and 1.59 g of a 30% aqueous solution of sodium dodecylbenzenesulfonate were added thereto over 30 minutes, and the solution was heated to 60°C under nitrogen gas.

Next, a mixture of 16.7 g of methyl methacrylate, 4.8 g of isobornyl methacrylate, and 2.4 g of methacrylic acid was added thereto at 80°C over 60 minutes.

After addition, the reaction mixture was heated at 80°C for 90 minutes to obtain an emulsion including water-dispersible particles A-1 which have an average particle size of 100 nm and in which a shell is formed on the surface of the core.

In the obtained water-dispersible particles A-1, the ratio (hereinafter, "core/shell ratio") of the mass of the shell to the mass of the core was 3/1.

In addition, it was found that the polymer contained in the shell contained 10 mass% of a constitutional unit derived from an acid group-containing monomer.

[Synthesis Example 2]

170 g of distilled water, 100 g of 1,3-butadiene, 0.5 g of t-dodecyl mercaptan, 0.3 g of potassium persulfate, 2.5 g of sodium rosinate, and 0.1 g of sodium hydroxide were charged into an autoclave equipped with a stirrer, and the solution was reacted at 70°C for 15 hours and cooled to terminate the reaction.

From the obtained conjugated diene-based copolymer latex, unreacted monomers were removed by steam distillation to obtain a core emulsion including a core (conjugated diene-based copolymer) having a number average particle size of 90 nm.

Next, 200 g of the core emulsion and 0.047 g of potassium persulfate were added to a flask. 127 g of distilled water and 1.55 g of a 30% aqueous solution of sodium dodecylbenzenesulfonate were added thereto over 30 minutes, and the solution was heated to 60°C under nitrogen gas.

Next, a mixture of 16.3 g of methyl methacrylate, 4.7 g of isobornyl methacrylate, and 2.3 g of methacrylic acid was added thereto at 80°C over 60 minutes.

After addition, the reaction mixture was heated at 80°C for 90 minutes to obtain an emulsion including water-dispersible particles A-2 which have an average particle size of 100 nm and in which a shell is formed on the surface of the core.

In the obtained water-dispersible particles A-2, the ratio (hereinafter, "core/shell ratio") of the mass of the shell to the mass of the core was 3/1.

In addition, it was found that the polymer contained in the shell contained 10 mass% of a constitutional unit derived from an acid group-containing monomer.

[Synthesis Examples 3-29]

Emulsions including water-dispersible particles A-3 to A-29 were synthesized by the method of Synthesis Example 1 or 2 according to the core composition and shell composition of Tables 1 and 2.

The average particle size of each of the obtained water-dispersible particles was 100 nm, and in each of the water-dispersible particles, the ratio (hereinafter, "core/shell ratio") of the mass of the core to the mass of the shell was as shown in Tables 1 and 2.

In addition, the abbreviations used in Tables 1 and 2 are as follows.

<Abbreviation>

· MMA: methyl methacrylate
· DMA: dodecyl methacrylate
· BMA: n-butyl methacrylate
· EA: ethyl acrylate
· BA: n-butyl acrylate
· i-BA: isobutyl acrylate
· IBMA: isobornyl methacrylate
· DCPMA: dicyclopentanyl methacrylate
· ADMA: adamantyl methacrylate
· AAm: acrylamide
· AN: acrylonitrile
· MCN: methacrylonitrile
· DVB: divinylbenzene
· MAA: methacrylic acid
· MAA-Na: sodium methacrylate
· AA: acrylic acid
· pSS-Na: sodium styrene sulfonate
· AMPS: 2-acrylamide-2-methylpropanesulfonic acid
· AMPS-Na: sodium 2-acrylamide-2-methylpropanesulfonate

[Table 1]

| | Water-dispersible particles | Core/shell ratio | Core composition | | | | | | | Glass transition temperature (°C) |
| | | | Content of constitutional unit derived from following monomer ( mass%) | | | | | | | |
| | | | 2-ethylhexyl acrylate | allyl methacrylate | 1,4-butanediol diacrylate | 1,3-butadiene | MMA | DMA | BA | |
|---|---|---|---|---|---|---|---|---|---|---|
| 1 | A-1 | 3/1 | 98 | 1 | 1 | | | | | -70 |
| 2 | A-2 | 3/1 | | | | 100 | | | | -85 |
| 3 | A-3 | 5/1 | | | | 70 | 30 | | | -52 |
| 4 | A-4 | 3/1 | | | | 100 | | | | -85 |
| 5 | A-5 | 2/1 | | | | | | 100 | | -65 |
| 6 | A-6 | 2/1 | | | | 60 | 40 | | | -38 |
| 7 | A-7 | 3/1 | | | | 100 | | | | -85 |
| 8 | A-8 | 3/1 | | | | 100 | | | | -85 |
| 9 | A-9 | 3/1 | | | | 100 | | | | -85 |
| 10 | A-10 | 3/1 | | | | | | 100 | | -65 |
| 11 | A-11 | 3/1 | | | | 100 | | | | -85 |
| 12 | A-12 | 1/1 | | | | | 40 | 60 | | -19 |
| 13 | A-13 | 2/1 | | | | 100 | | | | -85 |
| 14 | A-14 | 2/1 | | | | 100 | | | | -85 |
| 15 | A-15 | 2/1 | | | | 100 | | | | -85 |
| 16 | A-16 | 2/1 | | | | 100 | | | | -85 |
| 17 | A-17 | 2/1 | | | | 100 | | | | -85 |
| 18 | A-18 | 2/1 | | | | 100 | | | | -85 |
| 19 | A-19 | 2/1 | | | | 100 | | | | -85 |
| 20 | A-20 | 2/1 | | | | 100 | | | | -85 |
| 21 | A-21 | 2/1 | | | | 100 | | | | -85 |
| 22 | A-22 | 2/1 | | | | 100 | | | | -85 |
| 23 | A-23 | 1/1 | | 1 | 1 | | | | 98 | -54 |

EP 3 842 862 B1

| | Water-dispersible particles | Core/shell ratio | Core composition | | | | | | | Glass transition temperature (°C) |
|---|---|---|---|---|---|---|---|---|---|---|
| | | | Content of constitutional unit derived from following monomer ( mass%) | | | | | | | |
| | | | 2-ethylhexyl acrylate | allyl methacrylate | 1,4-butanediol diacrylate | 1,3-butadiene | MMA | DMA | BA | |
| 24 | A-24 | 2/1 | | 1 | 1 | | | | 98 | -54 |
| 25 | A-25 | 1/2 | | | | 100 | | | | -85 |
| 26 | A-26 | 2/1 | | | | 70 | 30 | | | -52 |
| 27 | A-27 | 2/1 | | | | 100 | | | | -85 |
| 28 | A-28 | 3/1 | | | | 100 | | | | -85 |
| 29 | A-29 | 1/3 | | | | 90 | 10 | | | -75 |
| 30 | A-30 | 2/1 | | | | 100 | | | | -85 |

EP 3 842 862 B1

[Table 2]

| | Shell composition | | | | | | | | | | | | | | | | | | | Glass transition temperature (°C) |
| | Content of constitutional unit derived from following monomer ( mass%) | | | | | | | | | | | | | | | | | | | |
| | 1,3-butadiene | Stylene | MMA | BMA | EA | BA | i-BA | IBMA | DCPMA | ADMA | AAm | AN | MCN | DVB | MAA | MAA-Na | AA | pSS-Na | AMPS | AMPS-Na | |
| 1 | | | 70 | | | | | 20 | | | | | | | 10 | | | | | | 126 |
| 2 | | | 70 | | | | | 20 | | | | | | | 10 | | | | | | 126 |
| 3 | | | 59 | | | | | | 21 | | | | | | 20 | | | | | | 135 |
| 4 | | | 70 | | | | | 20 | | | | | | | 5 | 5 | | | | | 126 |
| 5 | | | 90 | | | | | | | 5 | | | | | 5 | | | | | | 112 |
| 6 | | | 80 | | | | | | | | | 10 | | | 5 | 5 | | | | | 118 |
| 7 | | | 75.5 | | | | | 19.5 | | | | | | | | 5 | | | | | 121 |
| 8 | | | 71.5 | | | | | 19 | | | | | | | | | | 9.5 | | | 114 |
| 9 | | | 66 | | | | | 23.5 | | | | | | | | | | | | 10.5 | 113 |
| 10 | | | 85 | | | | | 10 | | | | | | | | | | | 5 | | 111 |
| 11 | | | 80 | | | | | | 19 | | | | | | 1 | | | | | | 115 |
| 12 | | | | 50 | | | | 40 | | | | | | | 5 | 5 | | | | | 81 |
| 13 | | | | 60 | | | | 30 | | | | | | | 5 | 5 | | | | | 68 |
| 14 | | | | 87 | | | | 3 | | | | | | | 5 | 5 | | | | | 37 |
| 15 | 42 | | | | | | | 47.5 | | | | | | 0.5 | 5 | 5 | | | | | 30 |
| 16 | 30 | | | | | | | 59.5 | | | | | | 0.5 | 5 | 5 | | | | | 62 |
| 17 | 18 | | | | | | | 71.5 | | | | | | 0.5 | 5 | 5 | | | | | 102 |
| 18 | | 90 | | | | | | | | | | | | | 5 | 5 | | | | | 112 |
| 19 | | 70 | | | | | | | 20 | | | | | | 5 | 5 | | | | | 126 |
| 20 | | 45 | 45 | | | | | | | | | | | | 5 | 5 | | | | | 114 |
| 21 | 20 | | | | | | | | | | | | 79.5 | 0.5 | | | | | | | 94 |
| 22 | 20 | | | | | | | 74.5 | | | | | | 0.5 | | | | | | 5 | 87 |
| 23 | | | 90 | | | | | | | | | | | | 10 | | | | | | 115 |
| 24 | | | 85 | | | 5 | | | | | | | | | 10 | | | | | | 117 |
| 25 | | 70 | | | | | | | 20 | | | | | | 5 | 5 | | | | | 126 |
| 26 | | | 80 | | | | | | | | | 10 | | | 5 | 5 | | | | | 116 |
| 27 | | | | 30 | | 60 | | | | | | | | | 5 | 5 | | | | | -4 |
| 28 | | | | | | | 90 | | | | | | | | 5 | 5 | | | | | -12 |
| 29 | | | | | 22.5 | 67 | | | | | | | | | | | | | | 10.5 | -38 |
| 30 | 60 | 10 | | | | 23 | | | | | | | | | 5 | | 2 | | | | -59 |

[Example 1]

[Production of laminate of infrared ablation layer/protective film]

28.8 g of carbon black (manufactured by Mitsubishi Chemical Corporation, MA8), 28.8 g of an acrylic resin (manufactured by Negami Chemical Industrial Co., Ltd., Hi-pearl M4501), and 4.5 g of a plasticizer (manufactured by FUJIFILM Wako Pure Chemical Corporation, tributyl O-acetylcitrate) were added to 105.2 g of methyl isobutyl ketone, and the solution was mixed by stirring with blade. The obtained mixed solution was dispersed using a three-roll mill, and methyl isobutyl ketone was further added thereto so that the solid content was 15 mass% to obtain a paint. Next, the paint was applied to a PET film having a thickness of 100 $\mu$m using a bar coater so that the thickness of the coating film after drying was 2 $\mu$m, and the film was dried at 120°C for 5 minutes to obtain a laminate of infrared ablation layer/protective film.

[Production of precursor for printing]

100 g of the emulsion including 25 g of the water-dispersible particles A-1 synthesized in Synthesis Example 1 and 15 g of a polyfunctional monomer (manufactured by NOF CORPORATION, 1,9-nonanediol dimethacrylate) as a photopolymerizable monomer C-1 were mixed with each other, and moisture was evaporated for 2 hours in a dryer heated to 120°C to obtain a mixture of water-dispersible particles and photopolymerizable monomers. This mixture, 17 g of SBS (manufactured by Asahi Kasei Corporation, TUFPRENE 315) as a hydrophobic polymer B-3, 17 g of liquid polybutadiene (manufactured by NIPPON SODA CO., LTD., B3000) as a plasticizer E-4, and 4 g of sodium laurate (manufactured by Kao Corporation, EMAL 0) as a surfactant F-1 were kneaded in a kneader for 45 minutes. Thereafter, 0.1 g of a polymerization inhibitor [manufactured by Seiko Chemical Co., Ltd., MEHQ (hydroquinone monomethyl ether)] as a thermal polymerization inhibitor G-1, 1 g of IRGACURE 651 (manufactured by BASF SE) as a photopolymerization initiator D-1, and 0.02 g of Tinuvin 326 (manufactured by BASF SE) as an ultraviolet absorber H-1 were added to the kneader and kneaded for 5 minutes to obtain a photosensitive resin composition. Using a substrate in which an adhesive is applied in advance to one surface of a PET film having a thickness of 125 $\mu$m and a protective film in which an anti-adhesion agent is applied in advance to one surface of a PET film having a thickness of 100 $\mu$m, the photosensitive resin composition obtained as described above was interposed between the protective film and the substrate, and the laminate was pressed with a press machine heated to 120°C so that the thickness of the photosensitive resin composition is 1 mm, thereby producing a precursor 1 for printing in which an adhesive layer, a photosensitive layer composed of the photosensitive resin composition, an anti-adhesion agent layer, and the protective film was laminated on the substrate in this order.

[Evaluation of water developability]

After peeling off the protective film of the precursor 1 for printing in Example 1, the precursor 1 for printing was developed at a liquid temperature of 40°C for 15 minutes, using a brush type washing machine containing a nonionic surfactant and a developer which contains sodium carbonate and has a pH of 10. The difference between the initial thickness (1.14 mm) of the plate and the thickness of the developed plate was defined as a developing amount (A) for 15 minutes. Based on the amount of washing out by this development for 15 minutes, the time (X) for developing 0.6 mm was calculated and defined as a development time. The development time (X) was obtained from the following expression.

$$X \ (min) = (15 \ (min) \ / \ A \ (mm)) \ x \ 0.6$$

A case where X was 20 minutes or less is defined as A (practically usable), a case where X was 30 minutes or less is defined as B (practical lower limit), and a case where X was more than 30 minutes is defined as C (practically useless). The results are shown in Table 3 below.

[Evaluation of adhesion and aggregating properties]

The above-described water development was repeated with the precursor 1 for printing having the same formulation to obtain a development waste liquid having a concentration of solid contents of 5%. 0.5 g of this development waste liquid was collected in a polypropylene container and diluted to 50 g with tap water. Thereafter, after stirring for 30 seconds, the state of dregs aggregation after 10 minutes was observed. In addition, after allowing to stand for 24 hours, the state of dregs adhering to the container wall was observed. A case where no dregs aggregated or adhered to the container wall was observed is defined as A (practically usable), a case where a slight white line was observed only at the gas-liquid interface is defined as B (practical lower limit), and a case where aggregates or adhesion to the container wall was observed is defined as C (practically useless). The results are shown in Table 3 below.

[Examples 2-26 and Comparative Examples 1-4]

A photosensitive resin composition was prepared in the same manner as in Example 1 with the composition of the components shown in Table 3.
Next, a precursor for printing was produced and evaluated in the same manner as in Example 1, except that each of the prepared photosensitive resin composition was used.
The abbreviations used in Table 3 are as follows.

<Hydrophobic polymer>

· B-1: NBR (manufactured by ZEON CORPORATION, NIPOL DN401)
· B-2: BR (manufactured by ZEON CORPORATION, NIPOL BR1220)
· B-3: SBS (manufactured by Asahi Kasei Corporation, TUFPRENE 315)
· B-4: SIS (manufactured by JSR Corporation, SIS5250)
B-5: methyl polymethacrylate-butyl polyacrylate-methyl polymethacrylate (manufactured by KURARAY CO., LTD., KURARITY LA2140)

<Photopolymerizable monomer>

· C-1: polyfunctional monomer (manufactured by NOF CORPORATION, 1,9-nonanediol dimethacrylate)
· C-2: polyfunctional monomer (manufactured by KYOEISHA CHEMICAL Co., LTD., 1,6-hexanediol dimethacrylate)
· C-3: monofunctional monomer (manufactured by KYOEISHA CHEMICAL Co., LTD., lauryl methacrylate)

<Photopolymerization initiator>

· D-1: IRGACURE 651 manufactured by BASF SE
· D-2: IRGACURE 184 manufactured by BASF SE

\<Plasticizer>

· E-1: bis(2-butoxyethyl) adipate (manufactured by ADEKA Corporation, RS-540)
· E-2: liquid paraffin (manufactured by Esso Mobil Corporation, Crystol 70)
· E-3: liquid polybutadiene (manufactured by KURARAY CO., LTD., LBR-352)
· E-4: liquid polybutadiene (manufactured by NIPPON SODA CO., LTD., B3000)
· E-5: acrylic liquid polymer (manufactured by KURARAY CO., LTD., LA1114)

\<Surfactant>

· F-1: sodium laurate (manufactured by Kao Corporation, EMAL 0)
· F-2: sodium alkylbenzene sulfonate (manufactured by NOF CORPORATION, NUWREX R)

\<Other components>

· G-1: polymerization inhibitor [manufactured by Seiko Chemical Co., Ltd., MEHQ (hydroquinone monomethyl ether)]
· H-1: ultraviolet absorber (manufactured by BASF SE, Tinuvin 326)

[Table 3]

| | Water-dispersible particles | | Hydrophobic polymer | Photopolymerizable monomer | Photopolymerization initiator | Plasticizer | Surfactant | Other components | Evaluation | |
| --- | --- | --- | --- | --- | --- | --- | --- | --- | --- | --- |
| | Type (Table 1) | Core /shell ratio | | | | | | | Water developability | Aggregation/adhesion |
| Example 1 | A-1 | 3/1 | B-3 | C-1 | D-1 | E-4 | F-1 | G-1 H-1 | A | A |
| Example 2 | A-2 | 3/1 | B-1 | C-1 | D-1 | E-1 | F-1 | G-1 H-1 | A | A |
| Example 3 | A-3 | 5/1 | B-5 | C-1 | D-1 | E-1 | - | G-1 H-1 | A | A |
| Example 4 | A-4 | 3/1 | B-5 | C-1 | D-1 | E-5 | - | G-1 H-1 | A | A |
| Example 5 | A-5 | 2/1 | B-5 | C-1 | D-1 | E-5 | F-2 | G-1 H-1 | A | A |
| Example 6 | A-6 | 2/1 | B-5 | C-1 | D-1 | E-5 | - | G-1 H-1 | A | A |
| Example 7 | A-7 | 3/1 | B-5 | C-1 | D-1 | E-5 | F-2 | G-1 H-1 | A | A |
| Example 8 | A-8 | 3/1 | B-2 | C-1 | D-1 | E-3 | - | G-1 H-1 | A | A |
| Example 9 | A-9 | 3/1 | B-5 | C-1 | D-1 | E-5 | - | G-1 H-1 | A | A |
| Example 10 | A-10 | 3/1 | B-3 | C-1 | D-1 | E-2 | F-2 | G-1 H-1 | A | A |
| Example 11 | A-11 | 3/1 | B-3 | C-2 | D-2 | E-3 | F-2 | G-1 H-1 | B | A |
| Example 12 | A-12 | 1/1 | B-3 | C-2 | D-2 | E-4 | - | G-1 H-1 | A | A |

EP 3 842 862 B1

17

| | Water-dispersible particles | | Hydrophobic polymer | Photopolymerizable monomer | Photopolymerization initiator | Plasticizer | Surfactant | Other components | Evaluation | |
|---|---|---|---|---|---|---|---|---|---|---|
| | Type (Table 1) | Core/shell ratio | | | | | | | Water developability | Aggregation/adhesion |
| Example 13 | A-13 | 2/1 | B-4 | C-2 | D-2 | E-1 | - | G-1 H-1 | A | A |
| Example 14 | A-14 | 2/1 | B-3 | C-2 | D-2 | E-1 | - | G-1 H-1 | B | A |
| Example 15 | A-15 | 2/1 | B-3 | C-1 | D-1 | E-2 | - | G-1 H-1 | B | A |
| Example 16 | A-16 | 2/1 | B-3 | C-1 | D-1 | E-2 | - | G-1 H-1 | A | A |
| Example 17 | A-17 | 2/1 | B-3 | C-1 | D-1 | E-2 | - | G-1 H-1 | A | A |
| Example 18 | A-18 | 2/1 | B-3 | C-1 | D-1 | E-2 | - | G-1 H-1 | A | B |
| Example 19 | A-19 | 2/1 | B-3 | C-1 | D-1 | E-2 | - | G-1 H-1 | A | A |
| Example 20 | A-20 | 2/1 | B-3 | C-1 | D-1 | E-2 | - | G-1 H-1 | A | B |
| Example 21 | A-21 | 2/1 | B-3 | C-1 | D-1 | E-2 | F-2 | G-1 H-1 | A | A |
| Example 22 | A-22 | 2/1 | B-3 | C-1 | D-1 | E-2 | F-2 | G-1 H-1 | A | A |
| Example 23 | A-23 | 1/1 | B-3 | C-1 | D-1 | E-4 | F-2 | G-1 H-1 | A | B |
| Example 24 | A-24 | 2/1 | B-3 | C-1 | D-1 | E-4 | F-2 | G-1 H-1 | A | A |

(continued)

| | Water-dispersible particles | | Hydrophobic polymer | Photopolymerizable monomer | Photopolymerization initiator | Plasticizer | Surfactant | Other components | Evaluation | |
|---|---|---|---|---|---|---|---|---|---|---|
| | Type (Table 1) | Core/shell ratio | | | | | | | Water developability | Aggregation/adhesion |
| Example 25 | A-25 | 1/2 | B-3 | C-1 | D-1 | E-2 | - | G-1 H-1 | A | B |
| Example 26 | A-26 | 2/1 | B-5 | C-1 | D-1 | E-5 | - | G-1 H-1 | A | A |
| Comparative Example 1 | A-27 | 2/1 | B-3 | C-1 | D-1 | E-1 | - | G-1 H-1 | C | C |
| Comparative Example 2 | A-28 | 3/1 | B-3 | C-1 | D-1 | E-1 | - | G-1 H-1 | C | C |
| Comparative Example 3 | A-29 | 1/3 | B-3 | C-1 | D-1 | E-1 | - | G-1 H-1 | C | C |
| Comparative Example 4 | A-30 | 2/1 | B-3 | C-1 | D-1 | E-1 | F-1 | G-1 H-1 | C | C |
| Examples 3, 11 and 21 are not according to the present invention. | | | | | | | | | | |

As shown in Tables 1-3, in any of flexographic printing plate precursors that have a photosensitive layer containing water-dispersible particles A-27 to A-30 which have a core containing a polymer and having a glass transition temperature of ≤ 0°C and have a shell containing a polymer and having a glass transition temperature of lower than 10°C, it could be seen that water developability is inferior and it is not possible to suppress the adhesion and aggregation of the dispersion in the developer (Comparative Examples 1-4).

On the other hand, in any of flexographic printing plate precursors that have a photosensitive layer containing water-dispersible particles A-1 to A-26 which have a core containing a polymer and having a glass transition temperature of ≤ 0°C and have a shell containing a polymer and having a glass transition temperature of ≥ 10°C, it could be seen that water developability is good, and adhesion and aggregating properties can be suppressed even in a case where the dispersion included in the aqueous developer assuming repeated used is diluted with water assuming the rinsing step (Examples 1-26).

In particular, from the comparison between Example 4 and Example 11, it could be seen that, in a case where the polymer contained in the shell of the water-dispersible particles contains 2-12 mass% of the constitutional unit derived from an acid group-containing monomer, the water developability is improved.

In addition, from the comparison of Examples 13-15, it could be seen that, in a case where the glass transition temperature of the core of the water-dispersible particles is -20°C or lower and the glass transition temperature of the shell is ≥ 40°C, the water developability is improved.

In addition, from the comparison of Examples 18-20, it could be seen that, in a case where the polymer contained in the shell of the water-dispersible particles has a constitutional unit derived from at least one monomer selected from an acrylic acid ester having an alicyclic $C_{\geq6}$-hydrocarbon group, a methacrylic acid ester having an alicyclic $C_{\geq6}$-hydrocarbon group, acrylamides, methacrylamides, acrylonitrile, and methacrylonitrile, adhesion and aggregating properties can be further suppressed.

In addition, from the comparison of Examples 19 and 25, it could be seen that, in a case where the ratio of the mass of the core to the mass of the shell is ≥ 1, adhesion and aggregating properties can be further suppressed.

**Claims**

1. A printing plate precursor, which is a water-developable flexographic printing plate precursor comprising a photosensitive layer containing water-dispersible particles which have

   - a core containing a polymer and having a glass transition temperature (Tg) of ≤ 0°C and
   - a shell containing a polymer and having a Tg of ≥ 10°C, the Tg being measured by DSC in accordance with JIS K 7121 (1987) by the method defined in the description,

   wherein the polymer contained in the shell contains 2-12 mass% of a constitutional unit derived from a monomer containing an acid group which is at least one acid group selected from a carboxy group, a sulfo group, a phosphoric acid group, and salts thereof and a constitutional unit derived from at least one monomer selected from acrylic and methacrylic acid esters having an alicyclic $C_{\geq6}$-hydrocarbon group, acrylamides, methacrylamides, acrylonitrile and methacrylonitrile.

2. The printing plate precursor of claim 1, wherein the Tg of the shell is ≥ 40°C.

3. The printing plate precursor of claim 1 or 2, wherein the polymer contained in the core has a constitutional unit derived from at least one monomer selected from $C_{2-12}$-acrylic acid esters, a $C_{6-14}$-methacrylic acid esters and conjugated diene-based hydrocarbons.

4. The printing plate precursor of any of claims 1-3, wherein the ratio of the mass of the core to the mass of the shell is ≥ 1.

5. A flexographic printing plate comprising an image area and a non-image area, wherein the image area is obtained by imagewise exposing the photosensitive layer of the printing plate precursor of any of claims 1-4, and developing the exposed photosensitive layer.

6. A photosensitive resin composition comprising a hydrophobic polymer; a photopolymerizable monomer; a photopolymerization initiator; and water-dispersible particles which have

   - a core containing a polymer and having a glass transition temperature (Tg) of ≤ 0°C and
   - a shell containing a polymer and having a Tg of ≥ 10°C, the Tg being measured by DSC in accordance with JIS K 7121 (1987) by the method defined in the description,

wherein the polymer contained in the shell contains 2-12 mass% of a constitutional unit derived from a monomer containing an acid group which is at least one acid group selected from a carboxy group, a sulfo group, a phosphoric acid group, and salts thereof and a constitutional unit derived from at least one monomer selected from acrylic and methacrylic acid esters having an alicyclic $C_{\geq 6}$-hydrocarbon group, acrylamides, methacrylamides, acrylonitrile and methacrylonitrile.

**7.** The photosensitive resin composition of claim 6, wherein the Tg of the shell is $\geq$ 40°C.

**8.** The photosensitive resin composition of claim 6 or 7, wherein the polymer contained in the core has a constitutional unit derived from at least one monomer selected from $C_{2-12}$-acrylic acid esters, a $C_{6-14}$-methacrylic acid esters and conjugated diene-based hydrocarbons.

**9.** The photosensitive resin composition of any of claims 6-8, wherein the ratio of the mass of the core to the mass of the shell is $\geq$ 1.

**Patentansprüche**

**1.** Druckplattenvorläufer, der ein wasserentwickelbarer Flexodruckplatten-Vorläufer ist, umfassend eine lichtempfindliche Schicht, die in Wasser dispergierbare Partikel enthält, die aufweisen:

- einen Kern, der ein Polymer enthält und eine Glasübergangstemperatur (Tg) von $\leq$ 0 °C aufweist, und
- eine Hülle, die ein Polymer enthält und eine Tg von $\geq$ 10 °C aufweist,

wobei die Tg durch DSC in Übereinstimmung mit JIS K 7121 (1987) durch das in der Beschreibung definierte Verfahren gemessen wird,
wobei das in der Hülle enthaltene Polymer 2-12 Massen-% einer Konstitutionseinheit abgeleitet von einem Monomer, das eine Säuregruppe, die mindestens eine Säuregruppe ist, die aus einer Carboxygruppe, einer Sulfogruppe, einer Phosphorsäuregruppe und Salzen davon ausgewählt ist, enthält, und einer Konstitutionseinheit abgeleitet von mindestens einem Monomer, das aus Acryl- und Methacrylsäureestern mit einer alizyklischen $C_{>6}$-Kohlenwasserstoffgruppe, Acrylamiden, Methacrylamiden, Acrylnitril und Methacrylnitril ausgewählt ist, enthält.

**2.** Druckplattenvorläufer nach Anspruch 1, wobei die Tg der Hülle $\geq$ 40 °C beträgt.

**3.** Druckplattenvorläufer nach Anspruch 1 oder 2, wobei das in dem Kern enthaltene Polymer eine Konstitutionseinheit abgeleitet von mindestens einem Monomer, das aus $C_{2-12}$-Acrylsäureestern, einem $C_{6-14}$-Methacrylsäureester und konjugierten dienbasierten Kohlenwasserstoffen ausgewählt ist, aufweist.

**4.** Druckplattenvorläufer nach einem der Ansprüche 1 bis 3, wobei das Verhältnis der Masse des Kerns zu der Masse der Hülle $\geq$ 1 ist.

**5.** Flexodruckplatte, umfassend einen Bildbereich und einen Nichtbildbereich, wobei der Bildbereich durch bildweises Belichten der lichtempfindlichen Schicht des Druckplattenvorläufers nach einem der Ansprüche 1 bis 4 und Entwickeln der belichteten lichtempfindlichen Schicht erhalten wird.

**6.** Lichtempfindliche Harzzusammensetzung, umfassend ein hydrophobes Polymer; ein photopolymerisierbares Monomer; einen Photopolymerisationsinitiator; und wasserdispergierbare Partikel, die aufweisen:

- einen Kern, der ein Polymer enthält und eine Glasübergangstemperatur (Tg) von $\leq$ 0 °C aufweist, und
- eine Hülle, die ein Polymer enthält und eine Tg von $\geq$ 10 °C aufweist,

wobei die Tg durch DSC in Übereinstimmung mit JIS K 7121 (1987) durch das in der Beschreibung definierte Verfahren gemessen wird,
wobei das in der Hülle enthaltene Polymer 2-12 Massen-% einer Konstitutionseinheit abgeleitet von einem Monomer, das eine Säuregruppe, die mindestens eine Säuregruppe ist, die aus einer Carboxygruppe, einer Sulfogruppe, einer Phosphorsäuregruppe und Salzen davon ausgewählt ist, enthält, und einer Konstitutionseinheit abgeleitet von mindestens einem Monomer, das aus Acryl- und Methacrylsäureestern mit einer alizyklischen $C_{\geq 6}$-Kohlenwasserstoffgruppe, Acrylamiden, Methacrylamiden, Acrylnitril und Methacrylnitril ausgewählt ist, enthält.

7. Lichtempfindliche Harzzusammensetzung nach Anspruch 6, wobei die Tg der Hülle $\geq$ 40 °C beträgt.

8. Lichtempfindliche Harzzusammensetzung nach Anspruch 6 oder 7, wobei das in dem Kern enthaltene Polymer eine Konstitutionseinheit abgeleitet von mindestens einem Monomer, das aus $C_{2\text{-}12}$-Acrylsäureestern, einem $C_{6\text{-}14}$-Methacrylsäureester und konjugierten dienbasierten Kohlenwasserstoffen ausgewählt wird, aufweist.

9. Lichtempfindliche Harzzusammensetzung nach einem der Ansprüche 6 bis 8, wobei das Verhältnis der Masse des Kerns zu der Masse der Hülle $\geq$ 1 ist.

**Revendications**

1. Précurseur de plaque d'impression, qui est un précurseur de plaque d'impression flexographique développable à l'eau comprenant une couche photosensible contenant des particules dispersibles dans l'eau qui ont

   - un noyau contenant un polymère et ayant une température de transition vitreuse (Tg) de $\leq$ 0 °C et
   - une enveloppe contenant un polymère et ayant une Tg de $\geq$ 10 °C,

   la Tg étant mesurée par DSC conformément à JIS K 7121 (1987) par la méthode défini dans la description, dans lequel le polymère contenu dans l'enveloppe contient 2-12 % en masse d'une unité constitutionnelle dérivée d'un monomère contenant un groupe acide qui est au moins un groupe acide choisi parmi un groupe carboxyle, un groupe sulfo, un groupe acide phosphorique et leurs sels, et une unité constitutionnelle dérivée d'au moins un monomère choisi parmi des esters d'acide acrylique et méthacrylique ayant un groupe hydrocarboné alicyclique $C_{>6}$, des acrylamides, des méthacrylamides, d'acrylonitrile et de méthacrylonitrile.

2. Précurseur de plaque d'impression selon la revendication 1, dans lequel la Tg de l'enveloppe est $\geq$ 40 °C.

3. Précurseur de plaque d'impression selon la revendication 1 ou la revendication 2, dans lequel le polymère contenu dans le noyau a une unité constitutionnelle dérivée d'au moins un monomère choisi parmi des esters d'acide acrylique $C_{2\text{-}12}$, des esters d'acide méthacrylique $C_{6\text{-}14}$ et des hydrocarbures à base de diène conjugué.

4. Précurseur de plaque d'impression selon l'une quelconque des revendications 1 à 3, dans lequel le rapport de la masse du noyau à la masse de l'enveloppe est $\geq$ 1.

5. Plaque d'impression flexographique comprenant une zone d'image et une zone sans image, dans laquelle la zone d'image est obtenue en exposant par images la couche photosensible du précurseur de plaque d'impression de l'une quelconque des revendications 1 à 4, et en développant la couche photosensible exposée.

6. Composition de résine photosensible comprenant un polymère hydrophobe ; un monomère photopolymérisable ; un initiateur de photopolymérisation ; et des particules dispersibles dans l'eau qui ont

   - un noyau contenant un polymère et ayant une température de transition vitreuse (Tg) de $\leq$ 0 °C et
   - une enveloppe contenant un polymère et ayant une Tg de $\geq$ 10 °C,

   la Tg étant mesurée par DSC conformément à JIS K 7121 (1987) par la méthode défini dans la description, dans lequel le polymère contenu dans l'enveloppe contient 2-12 % en masse d'une unité constitutionnelle dérivée d'un monomère contenant un groupe acide qui est au moins un groupe acide choisi parmi un groupe carboxyle, un groupe sulfo, un groupe acide phosphorique et leurs sels, et une unité constitutionnelle dérivée d'au moins un monomère choisi parmi des esters d'acide acrylique et méthacrylique ayant un groupe hydrocarboné alicyclique $C_{\geq 6}$, des acrylamides, des méthacrylamides, d'acrylonitrile et de méthacrylonitrile.

7. Composition de résine photosensible selon la revendication 6, dans laquelle la Tg de l'enveloppe est $\geq$ 40 °C.

8. Composition de résine photosensible selon la revendication 6 ou la revendication 7, dans laquelle le polymère contenu dans le noyau a une unité constitutionnelle dérivée d'au moins un monomère choisi parmi des esters d'acide acrylique $C_{2-12}$, des esters d'acide méthacrylique $C_{6-14}$ et des hydrocarbures à base de diène conjugué.

9. Composition de résine photosensible selon l'une quelconque des revendications 6 à 8, dans laquelle le rapport de la masse du noyau à la masse de l'enveloppe est $\geq 1$.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010256860 A
- JP 2017076059 A
- JP 5112655 A
- JP 5204139 A
- JP 5501457 A